# NEUE EUROPÄISCHE PATENTSCHRIFT

(11) **EP 0 927 356 B2**
(45) Veröffentlichungstag und Bekanntmachung des Hinweises auf die Entscheidung über den Einspruch: **19.01.2005**
(45) Hinweis auf die Patenterteilung: 03.04.2002
(21) Anmeldenummer: 97931785.6
(22) Anmeldetag: 05.07.1997
(51) Int. Cl.: G01P 21/02, G01R 31/00

(54) **VERFAHREN ZUR PRÜFUNG ELEKTRISCHER BAUTEILE UND VORRICHTUNG ZUR DURCHFÜHRUNG DES VERFAHRENS**
METHOD OF CHECKING ELECTRICAL COMPONENTS AND DEVICE FOR CARRYING OUT THIS METHOD
PROCEDE DE VERIFICATION DE COMPOSANTS ELECTRIQUES ET DISPOSITIF PERMETTANT DE METTRE LEDIT PROCEDE EN OEUVRE

(30) Priorität: 11.09.1996 DE 19636821
(43) Veröffentlichungstag der Anmeldung: 07.07.1999
(73) Patentinhaber: Continental Teves AG & Co. oHG, 60488 Frankfurt (DE)
(72) Erfinder: ZYDEK, Michael, D-35428 Langgöns (DE); FEY, Wolfgang, D-65527 Niedernhausen (DE); TRASKOV, Adrian, D-61449 Steinbach (DE)
(74) Vertreter: Blum, Klaus-Dieter, Dipl.-Ing.
(86) Internationale Anmeldenummer: PCT/EP1997/003563
(87) Internationale Veröffentlichungsnummer: WO 1998/011444

(56) Entgegenhaltungen:
- EP-A- 0 285 478
- EP-B- 0 190 411
- EP-B- 0 358 887
- WO-A-91/11757
- WO-A-93/20452
- WO-A-95/23975
- WO-A-96/00398

## Beschreibung

Die Erfindung betrifft ein Verfahren zur Prüfung elektrischer Bauteile in einem Kraftfahrzeug auf Funktionsfähigkeit, bei dem der Widerstandswert zwischen den Anschlußklemmen des elektrischen Bauteiles zumindest indirekt gemessen und zur Ermittlung der Funktionsfähigkeit des elektrischen Bauteils ausgewertet wird. Eine Vorrichtung zur Durchführung des Verfahrens gehört ebenfalls zur Erfindung.

Der Anmelderin ist es beispielsweise bekannt, im Zusammenhang mit der Erkennung von Funktionsstörungen eines Drehzahlsensors für die Messung der Drehzahl eines Rades bzw. einer Achse in einem Kraftfahrzeug eine Sensorabrißüberwachung vorzusehen. Wenn der Sensor dabei kein Signal mehr abgibt, wird darauf geschlossen, daß ein Sensorabriß vorliegt. Es kann weiterhin über die Auswertung des Sensorsignals eine Plausibilitätsprüfung vorgenommen werden. Damit kann beispielsweise erkannt werden, ob ein Kurzschluß des Sensors vorliegt. In diesem Falle entspricht das Sensorsignal nicht dem erwarteten Wert. Ein erwarteter Wert kann beispielsweise festgelegt werden durch einen Abgleich mit anderen Drehzahlsensoren am Fahrzeug.

Aus der WO-A-95/23975 ist bereits ein induktiver Geschwindigkeitssensor mit einer Auswerteschaltung bekannt, die eine Überwachungsschaltung enthält. Aus der Sensor-Induktivität und einem Kondensator wird ein Schwingkreis gebildet, der durch ein aktives Testsignal angeregt wird. Aus dem Abklingverhalten, nämlich der Abklingzeitspanne als Reaktion auf das Testsignal, werden eine Unterbrechung der Sensoranschlußleitung oder ein Kurzschluß erkannt. Ein weiteres Verfahren zum Testen eines Sensors, welches auf eine Zeitmessung basiert, wird in der EP-3-0 358 887 offenbart.

Ein weiteres Verfahren zur Überwachung von induktiven Sensoren ist in der WO-A-93/20452 beschrieben. Um auch einen Kurzschluß zwischen den Anschlußleitungen verschiedener Sensoren feststellen zu können, wird in eine Sensor-Anschlußleitung ein Testsignal eingespeist, das bei Kurzschluß eine Potentialänderung auch in der Anschlußleitung des anderen, kurzgeschlossenen Sensoranschlusses hervorruft.

Demgegenüber ist es die Aufgabe der vorliegenden Erfindung, die Erkennungvon Funktionsstörungen elektrischer Bauteile zu verbessern.

Erfindungsgemäß wird diese Aufgabe mit dem Verfahren nach Anspruch 1 gelöst.

Vorteilhaft wird dadurch erreicht, daß eine Erkennung von Funktionsstörungen mit geringerem Aufwand und auch mit einer gegenüber dem Stand der Technik geringeren zeitlichen Verzögerung erfolgen kann. Bei der Plausibilitätsprüfung des ausgewerteten Sensorsignals kommt es nämlich zu einer zeitlichen Verzögerung bis der Kurzschluß des Sensors verläßlich festgestellt werden kann.

Wenn eine Funktionsstörung erkannt wurde, kann unter Umständen der Fehler noch näher eingegrenzt werden, indem auf einen Kurzschluß geschlossen wird, wenn der gemessene Widerstandswert betragsmäßig um mehr als einen bestimmten Betrag geringer ist als der Sollwert. Ein hoher Übergangswiderstand an den Anschlußklemmen des elektrischen Bauteiles oder ein Drahtabriß im elektrischen Bauteil kann erkannt werden, wenn der gemessene Widerstandswert betragsmäßig um mehr als einen vorgegebenen Wert größer ist als der Sollwert. Vorteilhaft zeigt sich dabei, daß mit einer Meßgröße verschiedene Funktionsstörungen erkannt werden können. Dabei können diese Funktionsstörungen ihrer Ursache nach zusätzlich mit vergleichsweise geringem Aufwand näher eingegrenzt werden, indem diese Meßgröße mit verschiedenen Schwellwerten verglichen wird.

Das elektrische Bauteil wird mit einem Signal beaufschlagt, wobei der Widerstandswert des elektrischen Bauteiles gemessen wird durch eine Auswertung der Dämpfung der Amplitude des Signals durch das elektrische Bauteil.

Durch die Berücksichtigung des dynamischen Verhaltens kann vorteilhaft durch ein besonders einfaches Meßverfahren der Widerstandswert des elektrischen Bauteiles erfaßt werden auch wenn das elektrische Bauteil neben einem ohmschen auch einen induktiven und/oder kapazitiven Anteil hat.

Bei einer weiteren vorteilhaften Fortbildung dieses Verfahren Ist nach Anspruch 2 vorgesehen, daß das Signal ein impulsförmiges Signal ist. Ein solches Signal ist vergleichsweise einfach zu erzeugen. Außerdem wird die Dämpfung damit mit vergleichsweise geringem Aufwand meßbar.

In weiterer Ausgestaltung des Verfahrens werden gemäß Anspruch 3 zur Messung des Widerstandswertes wenigstens zwei impulsförmige Signale unterschiedlichen Vorzeichens erzeugt.

Dadurch kann die Dämpfung der Amplitude des impulsförmigen Signals zweimal erfaßt werden. Eventuelle Meßfehler können also insbesondere im Hinblick auf eine mögliche Nullpunktverschiebung leichter erkannt werden. Außerdem ist es dabei möglich, die Überprüfung mittels eines Schmitt-Triggers vorzunehmen, ohne dessen momentanen Zustand zu kennen. Wird das elektrische Bauteil nur mit einem Signal beaufschlagt, kann bei einem Ansprechen des Schmitt-Triggers nicht sicher gesagt werden, ob das Ansprechen auf einem Unter- bzw. Überschreiten der unteren oder der oberen Schwelle des Schmitt-Triggers beruht.

Bei einer Vorrichtung zur Durchführung des Verfahrens gemäß Anspruch 4 wird die Dämpfung des Signals ausgewertet, indem die Anschlußklemmen des elektrischen Bauteiles mit je einem Eingang eines Triggers verbunden sind.

Vorteilhaft kann also die Dämpfung ausgewertet werden, indem lediglich das Signal auf das Überschreiten einer bestimmten Amplitude überwacht wird. Es ist keine genaue Messung des Wertes der Amplitude notwendig, wodurch der Bauteileaufwand und damit auch die Kosten begrenzt werden.

Als besonders vorteilhaft erweist sich dies, wenn das elektrische Bauteil ein Sensor ist, dessen Signal im Normalbetrieb des Sensors mittels des Schmitt-Triggers ausgewertet wird. Der Schmitt-Trigger kann dann zusätzlich zur Prüfung der Funktionsfähigkeit des Sensors verwendet werden.

Bei einer Ausbildung der Vorrichtung nach Anspruch 5 ist die Hysterese des Triggers verstellbar.

Es können dann mehrere Schwellwerte des Widerstandes mit einem einzigen Trigger überwacht werden, indem die Hysterese des Triggers nacheinander auf die entsprechenden Werte der Hysterese eingestellt wird. Insbesondere kann also der zumindest indirekt gemessene Widerstandswert durch eine Anpassung der Hysterese des Triggers darauf hin überwacht werden, ob ein bestimmter unterer Wert des Widerstandes unterschritten oder ein bestimmter oberer Wert des Widerstandes überschritten wird.

Gemäß Anspruch 6 ist vorgesehen, daß alternativ oder zusätzlich die Amplitude des Signals verstellbar sein soll.

Auch damit ist es möglich, mehrere Schwellwerte des Widerstandes mit einem einzigen Trigger zu überwachen. Dabei werden die Amplituden entsprechend so eingestellt, daß sich bei normaler Funktion des Sensors ein entsprechender Wert am Eingang des Triggers einstellt.

Bei der Vorrichtung nach Anspruch 7 ist vorgesehen, daß wenigstens eine der beiden Anschlußklemmen des elektrischen Bautelles mit einem Ausgang eines Mikroprozessors verbunden ist und mittels des Mikroprozessors mit einem oder mehreren Signalen beaufschlagt wird zur Prüfung der Funktionsfähigkeit des elektrischen Bauteiles.

Dies erweist sich insbesondere dann als vorteilhaft, wenn das elektrische Bauteil ein Sensor ist, dessen Signale mittels des Mikroprozessors ausgewertet werden. In diesem Falle ist der Mikroprozessor ohnehin vorhanden, so daß dessen zusätzliche Verwendung zur Prüfung der Funktionsfähigkeit des Sensors vernachlässigbar geringe Kosten verursacht. Dabei kann die Auswertung des Signals erfolgen, indem der Sensor mit dem Eingang eines Schmitt-Triggers verbunden ist, dessen Ausgangssignal dem Mikroprozessor zugeführt wird. Da die Beaufschlagung des Sensors mit einem externen Signal durch den Mikroprozessor veranlaßt wird, kann in dem Mikroprozessor auch das Signal des Schmitt-Triggers entsprechend ausgewertet werden, da zu jeder Zeit in dem Mikroprozessor bekannt ist, ob der Sensor im Normalbetrieb läuft, das heißt die Meßgröße erfaßt, oder ob der Sensor mit einem Signal beaufschlagt wird, um den Sensor zu testen.

Es kann also mit einer solchen Vorrichtung die Funktionsfähigkeit des Sensors geprüft werden, indem an die Klemmen des Sensors ein Signal angelegt wird und die Dämpfung dieses Signals gemessen wird, indem die Klemmen des Sensors wiederum mit dem Eingang eines Schmitt-Triggers verbunden sind. Es wird dabei also die Dämpfung des Signals durch den Vierpol gemessen, der den Sensor als Bestandteil enthält.

Bei einer Ausgestaltung der Vorrichtung nach Anspruch 8 erfolgt die Erzeugung und Zuführung des Signals zum elektrischen Bauteil mittels eines Tristate-Port.

Durch diese Ausgestaltung der Vorrichtung wird der Bauteileaufwand insbesondere dann reduziert, wenn ein Mikroprozessor vorhanden ist. Mittels eines Mikroprozessors ist das Tristate-Port einfach zu realisieren.

Die Ausgestaltung der Vorrichtung nach Anspruch 9 beschreibt, daß das elektrische Bauteil ein Drehzahlsensor für die Messung der Drehzahl eines Rades bzw. einer Achse in einem Kraftfahrzeug sein kann.

Da die Funktion eines solchen Sensors sicherheitsrelevant ist, ist ein verbesserte Verfahren zur Funktionsüberprüfung sowie eine entsprechende Vorrichtung zur Durchführung des Verfahrens hier besonders sinnvoll. Weiterhin sind derartige Sensoren Bestandteile von Systemen, die üblicherweise ohnehin einen Schmitt-Trigger für die Auswertung des Sensorsignals umfassen sowie einen Mikroprozessor für weitere Anwendungen. Es können also die ohnehin vorhandenen Bauteile verwendet werden zur Funktionsüberprüfung des Sensors.

Ein Ausführungsbeispiel der Erfindung ist In der Zeichnung näher dargestellt. Es zeigen dabei im einzelnen:
- Fig. 1:: ein Ausführungsbeispiel einer in ihren Funktionsprinzipien dargestellten Vorrichtung zur Durchführung des Verfahrens,
- Fig. 2:: ein weiteres Ausführungsbeispiel zur Durchführung des Verfahrens,
- Fig. 3:: ein Beispiel für die Auswertung der gemessenen Signale zur Prüfung der Funktionsfähigkeit des elektrischen Bauteiles und
- Fig. 4:: eine Darstellung der Realisierung des Tristate-Port.

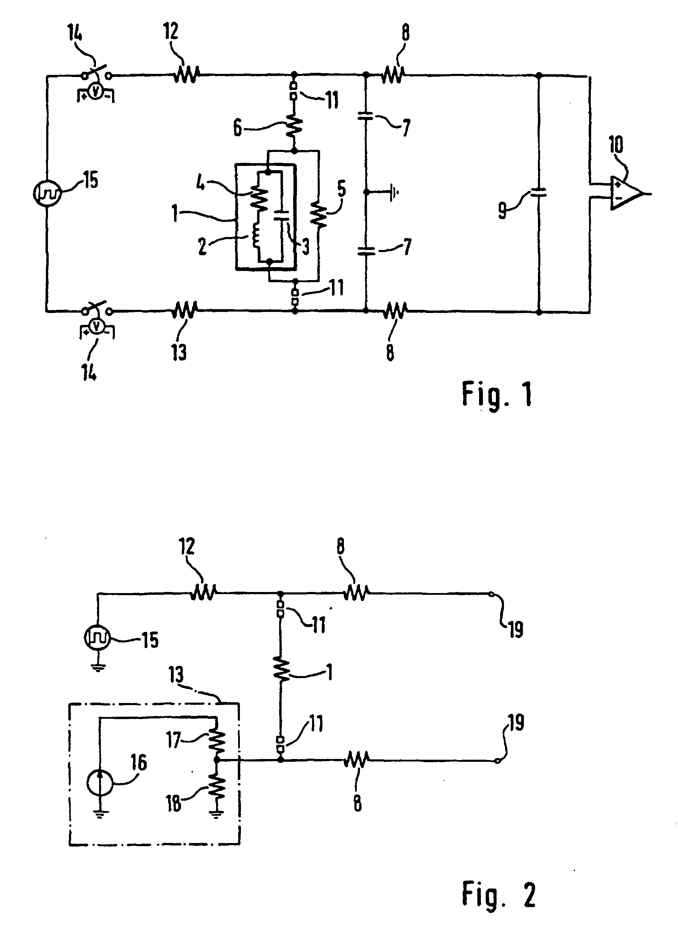

Anhand von Fig. 1 soll im folgenden das Funktionsprinzip des Verfahrens erläutert werden. Fig. 1 zeigt einen Sensor 1 zur Messung der Drehzahl eines Rades oder einer Achse in einem Kraftfahrzeug.

Dieser Sensor 1 ist zur Erläuterung des Verfahrens als Ersatzschaltbild dargestellt. Dieses Ersatzschaltbild besteht aus einer Reihenschaltung eines ohmschen Widerstandes 4, der mit einem induktiven Widerstand 2 in Reihe geschaltet ist. Dieser Reihenschaltung ist ein kapazitiver Widerstand 3 parallel geschaltet.

In dem Ersatzschaltbild der Fig. 1 ist weiterhin die Darstellung eines Widerstandes 5 zu sehen. Dieser Widerstand 5 ist der Nebenschlußwiderstand. Im Falle eines Kurzschlusses des Sensors 1 weist dieser Nebenschlußwiderstand 5 den Widerstandswert 0 auf.

Der Sensor 1 weist weiterhin Anschlußkontakte 11 auf. An diesen Anschlußkontakten 11 tritt ebenfalls ein Widerstand auf. Dieser Widerstand ist ersatzweise durch den Kontaktwiderstand 6 dargestellt. Dieser Kontaktwiderstand 6 wird beispielsweise dann größer, wenn die Anschlußkontakte 11 korrodiert sind.

Weiterhin ist eine Impulsspannungsquelle 15 vorgesehen, deren beide Anschlüsse über jeweils einen Meßschalter 14 sowie einen Meßwiderstand 12 bzw. 13 mit einem der Anschlußkontakte 11 des Sensors verbindbar sind.

Wie Fig. 1 zu entnehmen, sind weiterhin zwei Kondensatoren 7 zur elektrostatischen Entladung als Schutz vorgesehen sowie ein Filterkondensator 9.

Die Anschlußkontakte 11 des Sensors 1 sind weiterhin mit den Eingängen eines Triggers 10 verbunden.

Wenn die Meßschalter 14 geschlossen werden, werden von der Impulsspannungsquelle 15 Signale abgegeben, die bis zum Eingang des Triggers 10 von dem dazwischen liegenden Vierpol gedämpft werden. Da das Dämpfungsverhalten der anderen Bauteile bekannt ist, kann also bei einer Abweichung der gemessenen Dämpfung des Vierpoles von dem Sollwert der Dämpfung darauf geschlossen werden, daß der Widerstandswert des Sensors von seinem Sollwert abweicht. Dabei wird bei dem Trigger eine Hysterese vorgesehen. Der Sensor weist eine Kupferdrahtwicklung auf, deren Widerstandswert sich im relevanten Temperaturbereich um Größenordnungen von 50% ändern kann. Diese sich vergleichsweise stark ändernden Widerstandswerte entsprechen dabei dennoch einem funktionsfähigen Sensor. Die Breite der Hysterese muß so gewählt werden, daß die Widerstandswerte des Sensors, die bei verschiedenen Betriebsbedingungen auftreten können, innerhalb des Bandes des Triggers liegen.

Wenn die Anschlußkontakte 11 nicht korrodiert oder abgerissen sind (d.h., wenn der Kontaktwiderstand 6 seinen normalen Wert hat), wenn weiterhin kein Kurzschluß vorliegt (d.h. der Nebenschlußwiderstand 5 unendlich ist) und wenn der Sensor 1 im übrigen störungsfrei ist, stellt sich also bei einer bestimmten Amplitude der Impulse der Impulsspannungsquelle 15 entsprechend der Dämpfung des Vierpoles eine zugehörige Amplitude am Eingang des Triggers 10 ein. Diese zugehörige Amplitude kann mit dem Schwellwert des Triggers verglichen werden.

Wenn der Widerstandswert des Sensors 1 auf das Überschreiten bzw. Unterschreiten mehrerer Werte hin untersucht werden soll, kann die Amplitude der Impulse der Impulsspannungsquelle 15 verändert werden oder die Hysterese des Triggers 10.

Fig. 2 zeigt eine Vorrichtung zur Durchführung des Verfahrens, bei der zur Prüfung des Widerstandswertes des Sensors 1 dieser Sensor 1 auf mehrere Werte hin überprüfbar ist. Dazu ist in Figur 2 als Meßwiderstand 13 eine Anordnung vorgesehen, die aus einer Spannungsquelle 16 besteht, deren Spannungsniveau . auf unterschiedliche Werte eingestellt werden kann. Weiterhin ist ein Spannungsteiler vorgesehen, der aus einer Reihenschaltung der beiden Widerstandselemente 17 und 18 besteht. Durch eine entsprechende Einstellung des Spannungsniveaus der Spannungsquelle 16 kann die Hysterese des Triggers 10 auf unterschiedliche Werte eingestellt werden.

Die Anschlußklemmen 19 der Schaltung nach Fig. 2 werden an den Eingang eines Triggers 10 angeschlossen.

Im übrigen haben identische Bezugszeichen wie in Figur 1 in Figur 2 dieselbe Bedeutung. Von einer Erläuterung dieser Bauteile im Zusammenhang mit Figur 2 wird daher abgesehen. Ebenso ist das Ersatzschaltbild des Sensors 1 in Fig. 2 nicht mehr im einzelnen dargestellt.

Die Impulsspannungsquelle 15 und die beiden Meßschalter können in dem Ausführungsbeispiel nach Figur 2 durch ein Tristate-Port gebildet sein, das nicht im einzelnen dargestellt ist. Dieses Tristate-Port nimmt dabei folgende Zustände an "Port Tristate" = "Meßschalter aus, Normalbetrieb", "Port Low" = "Meßschalter ein, Sensor Test, Spannung Low" und "Port High" = "Meßschalter ein, Sensor Test, Spannung High".

Dieses Tristate-Port kann beispielsweise realisiert sein, indem die eine Anschlußklemme 11 des Sensors 1 an den Ausgang eines Mikroprozessors angeschlossen wird. Die Signale, mit denen der Sensor 1 beaufschlagt wird, werden dabei von dem Mikroprozessor generiert. Besonders vorteilhaft zeigt sich dabei bei einem Kraftfahrzeug, bei dem der Sensor 1 beispielsweise Bestandteil eines Antiblockiersystems ist, daß ohnehin ein Schmitt-Trigger sowie ein Mikroprozessor vorhanden ist, um die Signale des Sensors 1 im Normalbetrieb auszuwerten. Mit der Erfindung können also diese Bauteile zusätzlich genutzt werden, um eine Funktionsprüfung des Sensors 1 vorzunehmen.

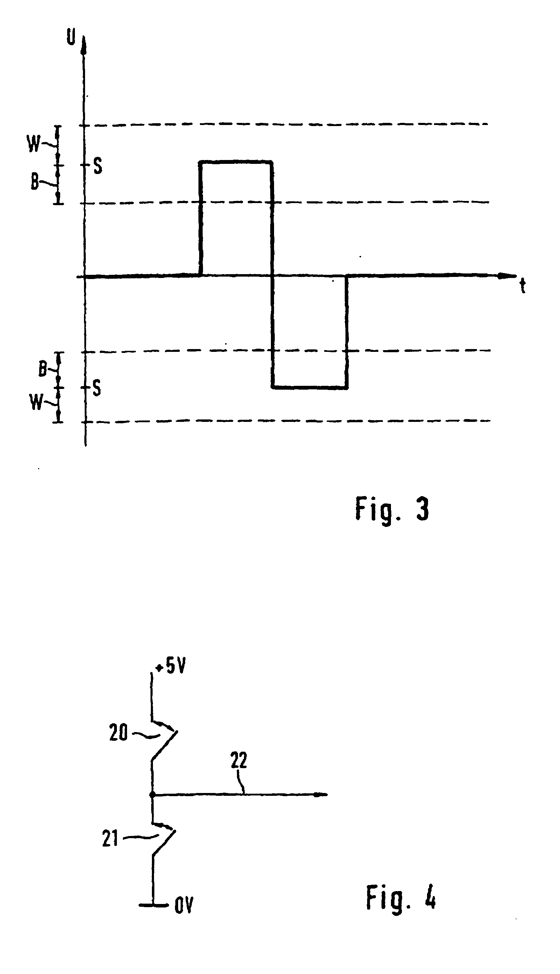

Fig. 3 zeigt ein Beispiel für die Auswertung der gemessenen Signale zur Prüfung der Funktionsfähigkeit des elektrischen Bauteiles. In Figur 3 ist das Signal am Eingang des Triggers 10 dargestellt als Spannung U über der Zeit t. Wie der Darstellung der Figur 3 zu entnehmen ist, weist die Amplitude des Signals genau den Sollwert S auf, der einem fehlerfreien Sensor 1 entspricht.

Weiterhin ist in Figur 3 eingezeichnet, daß ein unterer Schwellwert existiert, der betragsmäßig um einen bestimmten Betrag B kleiner ist als der Sollwert S. Unterschreitet das Signal am Eingang des Triggers 10 diesen unteren Schwellwert betragsmäßig, so liegt eine zu starke Dämpfung des Signals durch den Sensor 1 vor. Dies kann darauf zurückgeführt werden, daß ein Kurzschluß vorliegt.

Weiterhin ist in Figur 3 eingezeichnet, daß ein erster oberer Schwellwert existiert, der betragsmäßig um einen vorgegebenen Wert W größer ist als der Sollwert S. Wenn das Signal am Eingang des Triggers 10 diesen ersten oberen Schwellwert betragsmäßig überschreitet, so liegt eine zu geringe Dämpfung durch den Sensor 1 vor. Dies kann darauf zurückgeführt werden, daß der Widerstand des Sensors 1 zu groß ist.

Dafür gibt es im wesentlichen zwei Ursachen. Zum einen können die Anschlußkontakte 11 des Sensors 1 korrodiert sein und zum anderen kann ein Sensorabriß vorliegen. Im letzteren Fall wäre der Widerstand des Sensors 1 unendlich. Wenn lediglich die Anschfußkontakte 11 korrodiert sind, ist der Widerstandswert des Sensors 1 zwar vergrößert, aber hat immer noch einen endlichen Wert.

Der Widerstandswert des Sensors wird In dem beschriebenen Ausführungsbeispiel indirekt gemessen über eine Messung der Spannung, die über dem Sensor abfällt.

Fig. 4 zeigt die Darstellung einer Schaltung, mit der das Tristate-Port realisiert sein kann. Wenn die beiden Schalter 20 und 21 geöffnet sind, ist der Zustand "Port Tristate" gegeben, d.h. es liegt der Normalbetrieb vor. Wenn nur der Schalter 21 geschlossen wird, liegt der Zustand "Port Low" vor, d.h. es erfolgt eine Funktionsprüfung des Sensors mit niedriger Spannung. Wenn nur der Schalter 20 geschlossen wird, liegt der Zustand "Port High" vor, d.h. es erfolgt eine Funktionsprüfung des Sensors mit hoher Spannung.

Die Ausgangsleitung 22 des Tristate-Port ist dabei beispielsweise in dem Ausführungsbeispiel der Fig. 2 über den Meßwiderstand 12 mit der einen Anschlußklemme 11 des Sensors 1 verbunden.

## Patentansprüche

1. Verfahren zur Prüfung elektrischer Bauteile (1) in einem Kraftfahrzeug auf Funktionsfähigkeit, bei dem der Widerstandswert zwischen den Anschlußklemmen (11) des elektrischen Bauteiles (1) gemessen und zur Ermittlung der Funktionsfähigkeit des elektrischen Bauteils (1) ausgewertet wird, bei dem, das elektrische Bauteil (1) mit einem Signal (15) beaufschlagt wird, wobei der Widerstandswert des elektrischen Bauteiles (1) gemessen wird durch eine Auswertung der Amplitude und wobei der Dämpfung des Signals durch das elektrische Bauteil (1),
der gemessene Widerstandswert mit einem Sollwert (S) verglichen wird und daß auf eine Funktionsstörung des elektrischen Bauteils (1) erkannt wird, wenn der gemessene Widerstandswert betragsmäßig um mehr als einen bestimmten Betrag (B) geringer ist als der Sollwert (S) oder um mehr als einen vorgegebenen Wert (W) größer ist als der Sollwert (S).

2. Verfahren nach Anspruch 1, wobei das Signal (15) ein impulsförmiges Signal ist.

3. Verfahren nach Anspruch 1 oder 2, wobei zur Messung des Widerstandswertes wenigstens zwei impulsförmige Signale (15) unterschiedlichen Vorzeichens erzeugt werden.

4. Vorrichtung, mit der ein Verfahren nach Anspruch 1 ausgeführt wird, wobei die Anschlußklemmen (11) des elektrischen Bauteiles (1) mit je einem Eingang eines Triggers (10) verbunden sind.

5. Vorrichtung nach Anspruch 4, wobei die Hysterese des Triggers (10) verstellbar ist.

6. Vorrichtung zur Durchführung des Verfahrens nach Anspruch 1, 2 oder 3, wobei plitude des Signals verstellbar ist.

7. Vorrichtung nach einem der Ansprüche 4 bis 6, wobei wenigstens eine der beiden Anschlußklemmen (11) des elektrischen Bauteiles (1) mit einem Ausgang eines Mikroprozessors verbunden ist und mittels des Mikroprozessors mit einem oder mehreren Signalen beaufschlagt wird zur Prüfung der Funktionsfähigkeit des elektrischen Bauteiles (1).

8. Vorrichtung nach einem der Ansprüche 4 bis 7, wobei die Erzeugung und Zuführung des Signals zum elektrischen Bauteil mittels eines Tristate-Port erfolgt.

9. Vorrichtung nach einem der Ansprüche 4 bis 8, wobei das elektrische Bauteil (1) ein Drehzahlsensor für die Messung der Drehzahl eines Rades bzw. einer Achse in einem Kraftfahrzeug ist.

## Claims

1. A process of testing electric components (1) in an automotive vehicle for proper operation thereof, wherein the resistance value between the terminals (11) of the electric component (1) is measured at least indirectly and evaluated for determining proper operation of the electric component (1), **characterized in that** the at least indirectly measured resistance value is compared to a nominal value (S), and that malfunction of the electric component (1) is anticipated if the amount of the at least indirectly measured resistance value falls below the nominal value (S) by more than a predetermined amount (B), or exceeds the nominal value (S) by more than a predetermined value (W).

2. A process according to claim 1, **characterized in that** a signal (15) is applied to the electric component (1), with the resistance value of the electric component (1) being measured by evaluating the attenuation of the signal through the electric component (1).

3. A process according to claim 2, **characterized in that** the signal (15) is a pulse-shaped signal.

4. A process according to claims 2 or 3, **characterized in that** at least two pulse-shaped signals (15) of different signs are generated for measuring the resistance value.

5. An assembly for carrying out the process according to claim 1, **characterized in that** the terminals (11) of the electric component (1) are connected to one input each of a trigger (10).

6. An assembly according to claim 5, **characterized in that** the hysteresis of trigger (10) is adjustable.

7. An assembly for carrying out the process according to claims 2, 3 or 4, **characterized in that** the amplitude of the signal is adjustable.

8. An assembly according to any one of claims 5 to 7, **characterized in that** at least one of the two terminals (11) of the electric component (1) is connected to an output of a microprocessor, with the microprocessor applying one or several signals thereto for testing the operability of the electric component (1).

9. An assembly according to any one of claims 5 to 8, **characterized in that** the generation and supply of the signal to the electric component is effected through a Tristate Port.

10. An assembly according to any of claims 5 to 9, **characterized in that** the electric component (1) is a speed sensor for measuring the number of revolutions of a wheel or of an axle in an automotive vehicle.

## Revendications

1. Procédé de contrôle de composants électriques (1), situés dans un véhicule automobile, en ce qui concerne leur capacité de fonctionnement, selon lequel la valeur de résistance entre les bornes (11) du composant électrique (1) est mesurée au moins indirectement et est analysée en vue de la détermination de la capacité de fonctionnement du composant électrique (1), **caractérisé en ce que** la valeur de résistance mesurée au moins indirectement est comparée à une valeur de consigne (S) et **en ce qu'**il est constaté une perturbation de fonctionnement du composant électrique (1) lorsque la valeur de résistance mesurée au moins indirectement est, en valeur absolue, inférieure à la valeur de consigne (S) de plus qu'une valeur déterminée (B) ou supérieure à la valeur de consigne (S) de plus qu'une valeur préfixée (W).

2. Procédé suivant la revendication 1, **caractérisé en ce que** le composant électrique (1) est soumis à l'application d'un signal (15), la valeur de résistance du composant électrique (1) étant mesurée au moyen d'une analyse de l'amortissement du signal par le composant électrique (1).

3. Procédé suivant la revendication 2, **caractérisé en ce que** le signal (15) est un signal en forme d'impulsion.

4. Procédé suivant la revendication 2 ou 3, **caractérisé en ce que**, pour la mesure de la valeur de résistance, au moins deux signaux en forme d'impulsion (15) de signes différents sont produits.

5. Dispositif de mise en oeuvre du procédé suivant la revendication 1, **caractérisé en ce que** les bornes (11) du composant électrique (1) sont reliées chacune à une entrée respective d'un circuit de déclenchement (10).

6. Dispositif suivant la revendication 5, **caractérisé en ce que** l'hystérésis du circuit de déclenchement (10) est réglable.

7. Dispositif de mise en oeuvre du procédé suivant la revendication 2, 3 ou 4, **caractérisé en ce que** l'amplitude du signal est réglable.

8. Dispositif suivant l'une des revendications 5 à 7, **caractérisé en ce qu'**au moins, l'une des deux bornes (11) du composant électrique (1) est reliée à une sortie d'un microprocesseur et, au moyen du microprocesseur, est soumise à l'application d'un ou plusieurs signaux en vue du contrôle de la capacité de fonctionnement du composant électrique (1) .

9. Dispositif suivant l'une des revendications 5 à 8, **caractérisé en ce que** la production et l'envoi du signal au composant électrique s'effectuent au moyen d'un port trois états.

10. Dispositif suivant l'une des revendications 5 à 9, **caractérisé en ce que** le composant électrique (1) est un capteur de vitesse de rotation servant à mesurer la vitesse de rotation d'une roue ou d'un essieu dans un véhicule automobile.
